(19) Europäisches Patentamt
European Patent Office
Office européen des brevets

(11) Publication number: **0 070 201**
**B1**

(12) **EUROPEAN PATENT SPECIFICATION**

(45) Date of publication of patent specification: **23.01.85**

(51) Int. Cl.$^4$: **G 03 C 1/60,** G 03 F 7/08

(21) Application number: **82303710.6**

(22) Date of filing: **14.07.82**

(54) **A photosensitive composite.**

(30) Priority: **15.07.81 JP 111000/81**

(43) Date of publication of application:
**19.01.83 Bulletin 83/03**

(45) Publication of the grant of the patent:
**23.01.85 Bulletin 85/04**

(84) Designated Contracting States:
**DE FR GB**

(56) References cited:
**DE-A-2 657 922**
**GB-A-1 474 073**
**US-A-3 592 646**

(73) Proprietor: **KONISHIROKU PHOTO INDUSTRY CO. LTD.**
**No. 26-2, Nishishinjuku 1-chome Shinjuku-ku**
**Tokyo 160 (JP)**

(72) Inventor: **Yamamoto, Takeshi**
**4-2-1 Miyamae Suginami-ku**
**Tokyo (JP)**
Inventor: **Goto, Kiyoshi**
**1210-109 Kunugida-chi**
**Hachioji-shi Tokyo (JP)**

(74) Representative: **Ellis-Jones, Patrick George Armine et al**
**J.A. KEMP & CO. 14 South Square Gray's Inn**
**London WC1R 5EU (GB)**

**EP 0 070 201 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The present invention relates to a photosensitive composite for a lithographic printing plate material and photoresist material, which possesses good sensitivity, excellent chemical resistance and has a long press life.

It is known that an o-quinone diazide compound is decomposed to produce a five-membered carboxylic acid and to become alkali-soluble by irradiating with light. Accordingly, an o-quinone diazide compound is frequently used in a lithographic printing plate material, a photoresist material and the like to serve as a photosensitive component for obtaining a positive-positive type image. Further, one generally uses a photosensitive composite in which said o-quinone diazide compound and a novolak resin, as an alkali-soluble resin, are mixed together, with the purpose of increasing the mechanical strength and the chemical resistance of the image area.

Photosensitive composites of this kind possess lower photosensitivity as compared with the negative working photosensitive composites utilizing a photocrosslinking reaction, so that it takes longer to expose them to light in the plate-making process; a shortening of the working time and an improvement in the working efficiency is desirable.

As a result, a number of attempts have been made for the purpose of increasing the photosensitivity of the photosensitive composites comprising o-quinone diazide compound and alkali-soluble resin. For example, in Japanese Patent Examined Publication No. 19619/1981, there is described a method in which the photosensitivity is increased by adding a hydantoin and o-benzoic sulfimide. Such compounds have not so far proved to be successful; further the addition of hydantoin has the disadvantage that it makes the development tolerances smaller. Further, in Japanese Patent Publication Open to Public Inspection No. 73045/1980, it has been proposed that condensation products of hydroxy benzophenone and formaldehyde should be added. However, this proposal is accompanied by the disadvantage that a large amount of said condensation products must be added and the solubility of the unexposed area in the developing solution is increased, so that development tolerances are reduced. Again, in Japanese Patent Publication Open to Public Inspection No. 80022/1977, it is disclosed that a five-membered cyclic acid-anhydride such as phthalic anhydride, maleic anhydride and the like may be added. This has been the most effective method for increasing the photosensitivity. However, when used in connection with a lithographic printing plate material, the above-mentioned five-membered cyclic acid-anhydride has the disadvantage that the development tolerance is reduced when the product is stored under conditions of high temperature and/or humidity and also on prolonged storage and that the printing image area is apt to be spoiled by various chemicals used in the printing process such as those used for removing stains, for gumming up, etc. or dampening water containing alcohol, so that multiple printing cannot be performed.

Accordingly, it is an object of the present invention to provide a photosensitive composite, wherein the above-mentioned defects are reduced or eliminated to make the sensitivity greater, the preservability better and the processing chemical resistance greater, and in the case of a lithographic printing plate material the press life is not reduced even after storage.

We have found, according to the present invention, that the said object can be attained with a photosensitive composite containing an o-quinone diazide compound, an alkali-soluble resin and a six-membered cyclic acid-anhydride (a product comprising a six-membered acid-anhydride ring).

An o-quinone diazide compound is a compound having at least one o-quinone diazide group, and preferably o-benzoquinone diazide group or o-naphthoquinone diazide group, in the molecule, including the known compounds having various structures, for example the compounds which have been described in detail in J. Kosar, "Light Sensitive Systems", John Wiley & Sons, Inc. 1965, pp 339—353.

Particularly suitable o-quinone diazide compounds for use in this invention are the esters of a hydroxyl compound and an o-quinone diazide sulfonic acid, preferably an o-naphthoquinone diazide. Preferable hydroxyl compounds include condensation resins of a phenol and a carbonyl group-containing compound, particularly the resins obtained by condensation in the presence of an acid catalyst. Preferred phenols include phenol, cresol and pyrogallol; preferred carbonyl group-containing compounds include formaldehyde, benzaldehyde, and acetone.

Particularly preferred hydroxyl compounds include a phenol.formaldehyde resin, a cresol.formaldehyde resin, a pyrogallol.acetone resin, and a resorcinol benzaldehyde resin.

Specific examples of suitable o-quinone diazide compounds are the ester of benzoquinone-(1,2)-diazide sulfonic acid or naphthoquinone-(1,2)-diazide sulfonic acid and a phenol.formaldehyde resin or cresol.formaldehyde resin; the ester of naphthoquinone-(1,2)-diazide-(2)-5-sulfonic acid and resorcinol-benzaldehyde resin described in Japanese Patent Publication Open to Public Inspection No. 1044/1981; the ester of naphthoquinone-(1,2)-diazide sulfonic acid and pyrogallol.acetone resin described in US Patent No. 3 635 709; and the ester of naphthoquinone-(1,2)-diazide-(2)-5-sulfonic acid and resorcinol-pyrogallol-acetone copolymeric condensation product described in Japanese Patent Publication Open to Public Inspection No. 76346/1980. Other useful o-quinone diazide compounds include an ester of a polyester having a terminal hydroxyl group with o-naphthoquinone diazide sulfonyl chloride described in Japanese Patent Publication Open to Public Inspection No. 117503/1975; an ester of p-hydroxy styrene homopolymer or a copolymer of p-hydroxy styrene with one or more other copolymerizable monomers with o-naphthoquinone diazide sulfonyl chloride described in Japanese Patent Publication Open to Public

Inspection No. 113305/1975; the ester of o-quinone diazide sulfonic acid and bisphenol-formaldehyde resin described in Japanese Patent Exaamined Publication No. 229922/1979; the condensation product of o-quinone diazide sulfonyl chloride and the copolymer of an alkyl acrylate, an acryloyloxyalkyl carbonate and a hydroxyalkyl acrylate described in US Patent No. 3 859 099; the reaction prodcut of o-quinone diazide sulfonic acid and a copolymerization product of styrene and a phenol derivative described in Japanese Patent Examined Publication No. 17481/1974; an amide of a copolymer of p-amino-styrene and one or more other copolymerizable monomers and o-naphthoquinone diazide sulfonic acid or o-naphthoquinone diazide carbonic acid described in US Patent No. 3 759 711, and the ester of o-naphthoquinone diazide sulfonyl chloride and polyhydroxybenzophenone.

The content of said o-quinone diazide compounds in the composite is preferably 5—80% by weight of the total amount of the solid components in the composite and more preferably 10—50% by weight.

Preferred alkali-soluble resins for use in this invention include those obtained by condensing a phenol and an aldehyde in the presence of an acid catalyst. As for the said phenols, phenol, cresol and p-substituted phenols are typical examples. As for the aldehydes, formaldehyde is preferred. The preferred alkali-soluble resins are the so-called novolak resins which are obtained by the condensation of a phenol and formaldehyde, examples of which include a phenol.formaldehyde resin, a cresol.formaldehyde resin, a phenol.cresol.formaldehyde copolymeric condensation resin as described in Japanese Patent Publication Open to Public Inspection No. 57841/1980 and a copolymeric condensation resin of a p-substituted phenol, phenol or cresol and formaldehyde as described in Japanese Patent Publication Open to Public Inspection No. 127553/1980. The content of said alkali-soluble resin in the composites is preferably 30—90% by weight, and more preferably 50—85% by weight, of the total amount of the solid components in the composites.

The six-membered cyclic acid-anhydrides to be used in the invention are defined as compounds for products having a six-membered ring containing the

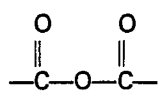

group which serves as part of the ring in the molecule. Said six-membered cyclic acid-anhydrides may either be condensed ring compounds, a low molecular weight compound or a macromolecular weight compound such as a polymer.

Preferred low molecular weight six-membered cyclic acid-anhydrides typically have the following formula (I):

Formula (I)

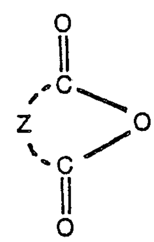

wherein Z represents the non-metal atoms necessary for forming a six-membered ring, together with

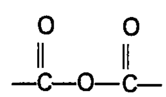

Z may comprise not only a carbon atom but also a hetero atom such as an oxygen atom, and the six-membered ring to be formed by Z may be either a saturated ring or an unsaturated ring.

Preferred such low molecular weight anhydrides have the following formula (II) or (III):

Formula (II)

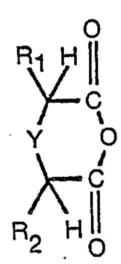

Formula (III)

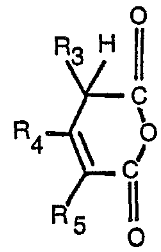

wherein Y represents an oxygen atom or a methylene group; and $R_1$, $R_2$, $R_3$, $R_4$ and $R_5$ each independently represents a hydrogen atom, an alkyl group, an aryl group or a halogen atom. A methylene group represented by Y may be substituted, for example, by an alkyl group, an aryl group or a halogen atom.

The alkyl or aryl group represented by $R_1$, $R_2$, $R_3$, $R_4$ or $R_5$ and the alkyl and aryl group which may be a substituent on the methylene group represented by Y can also be substituted. The substituents in this case are, for example, a halogen atom, an alkyl group such as a methyl group or a propyl group; an alkoxy group such as a methoxy group or an isopropoxy group; and an aryl group such as a phenyl group or a tolyl group.

Preferred macromolecular compounds are the polymers having one or more units derived from the six-membered cyclic acid-anhydrides of formula (I) in the molecule.

Said polymers may have a six-membered cyclic acid-anhydride unit in the principal chain or in a side chain thereof. Said polymers may also be copolymers having two or more six-membered cyclic acid-anhydride units. Typical polymers having a six-membered cyclic acid-anhydride unit in the principal chain include those having a monomer unit of the following formula (IV):

Formula (IV)

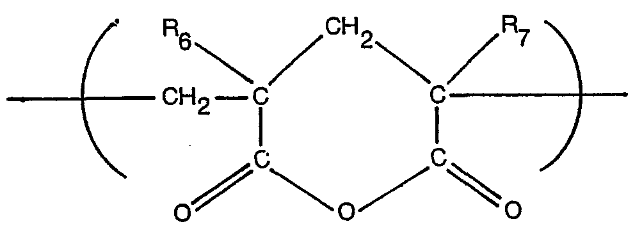

wherein $R_6$ and $R_7$ each independently represents a hydrogen atom, a halogen atom or an alkyl group. The alkyl groups represented by $R_6$ and $R_7$ may also have a halogen atom or an aryl group such as a phenyl group, for example, as a substituent.

The molecular weight of said polymer is suitably 1 000—50 000, and more preferably 15 000—30 000.

Specific anhydrides which can be used in this invention are exemplified below:

(1)

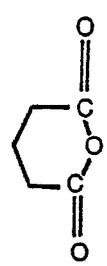

(2)

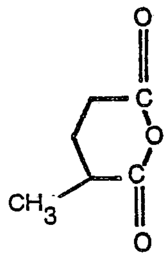

(3)

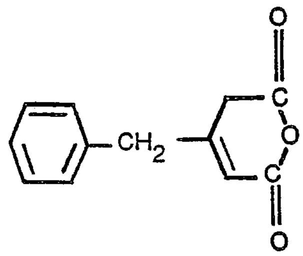

(4)

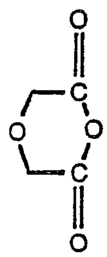

(5)

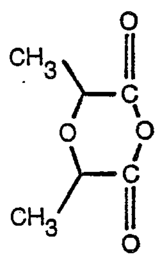

(6)

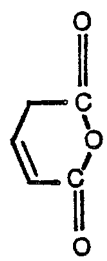

(7)

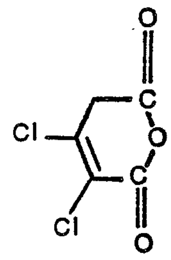

(8)

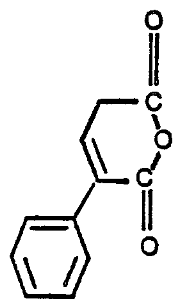

(9)

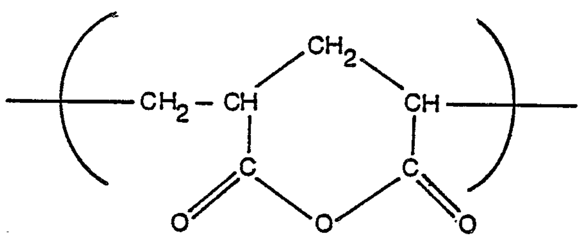

(M.W. 25,000)

(10)

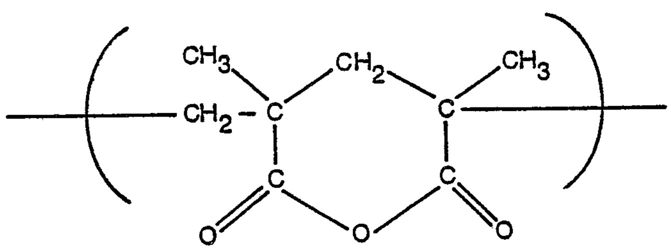

(M.W. 18,000)

(11)

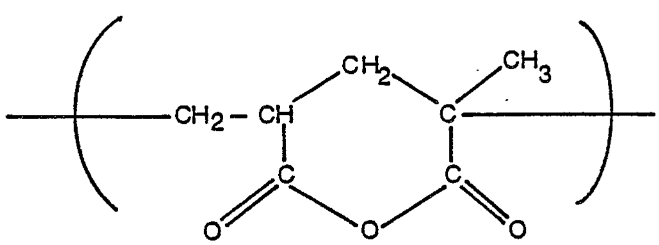

(M.W. 27,000)

The compounds of formula (I) can be prepared, for example, such that the corresponding dicarboxylic acid is heated up together with acetyl chloride or acetic anhydride, for example, to be cyclized on dehydration. The six-membered cyclic acid-anhydrides which are polymers can be prepared as described in C. G. Overberger, "Macromolecular Synthesis", vol. 1, pp 38-, John Wiley & Sons, Inc. 1963, such that an acrylic anhydride or a methacrylic anhydride is cyclopolymerized. Among said six-membered cyclic acid-anhydrides the compounds represented by the formula (II) are preferable, especially those wherein Y is a methylene group; glutaric anhydride is most preferable. The amount added of said six-membered cyclic acid-anhydride is preferably 0.5—20% by weight, particularly 1—8% by weight, and most preferably 2—5% by weight, based on the total amount of the solid components in the photosensitive composite. The sensitization effect is insignificant below an addition of 0.5% by weight and development latitude is not adversely affected below 20% by weight.

In addition to the aforesaid ingredients, a variety of additives may be included in the photosensitive composites of the invention as occasion demands. For example, for the purpose of improving the ink-acceptability a lipophilic phenol.formaldehyde resin and a p-substituted phenol.formaldehyde resin can be added as described in Japanese Patent Examined Publication No. 5083/1975, Japanese Patent Publication Open to Public Inspection No. 36206/1975 and US Patent No. 4 123 279, for example. As for the substituents in the p-substituted phenol.formaldehyde resin, there may be mentioned, for example, an alkyl group having 4—10 carbon atoms such as a t-butyl, t-amyl, octyl, benzyl or cumyl group, or an aryl group such as a phenyl or tolyl group.

There can also be used effectively a condensation product of the aforesaid phenol.formaldehyde resin and an o-quinone diazide compound having a halogeno-sulfonyl group.

Further, there can be added a cellulose alkyl ether, an ethylene oxide surface active agent or a fluorinated surface active agent to improve the coating properties.

Furthermore, a plasticizer can be added to improve the flexibility of the coat. For example, it is effective to add a phthalate ester such as dibutyl phthalate or dioctyl phthalate, a glycolate ester such as butyl glycolate, or ethylphthalyl ethyl glycolate, a phosphate ester such as triphenyl phosphate and tricresyl phosphate or an ester of aliphatic dibasic acid such as dioctyl adipate.

Still further, it is possible to add a print-out material for forming a visible image upon exposure to light. Said print-out material is usually a compound producing an acid or a free radical through exposure to light and an organic dye the color of which changes through interaction with said acid or radical; examples of such compounds include o-naphthoquinone diazide-4-sulfonyl halogenide, described in Japanese Patent Publication Open to Public Inspection No. 36209/1975, trihalomethyl-2-pyrone and trihalomethyl-triazine, described in Japanese Patent Publication Open to Public Inspection No. 36223/1978, an ester or an amide of o-naphthoquinone diazide-4-sulfonyl chloride and a phenol or an aniline having an electron attractive substituent, described in Japanese Patent Publication Open to Public Inspection No. 6244/1980, a halomethylvinyl oxadiazole compound, described in Japanese Patent Publication Open to Public Inspection No. 77742/1980, or a diazonium salt.

Suitable organic dyes which may be used include Victoria Pure Blue BOH (mfd. by Hodogaya Chemical Ind. Co. Ltd.), Patent Pure Blue (mfd. by Sumitomo Mikuni Chemical Ind. Co. Ltd.), Oil Blue No. 603 (mfd. by Orient Chemical Ind. Co. Ltd.), Sudan Blue II (mfd. by BASF), Crystal Violet, Malachite Green, Fuchsine, Methyl Violet, Ethyl Violet, Methyl Orange, Brilliant Green, Congo Red, Eosine and Rhodamine 6G. For the purpose of improving the adhesion of a photosensitive layer to a support, it is possible to add an adhesion reinforcer such as a silane coupling agent (e.g. an aminoalkoxy silane compound) as described in Japanese Patent Publication Open to Public Inspection No. 52002/1976.

Further, for the purpose of improving the abrasion resistance of a photosensitive layer obtained by coating the photosensitive composite of the invention, it is possible to add thereto a lipophilic macromolecular compound such as an epoxy resin, a copolymer of vinyl chloride and vinyl acetate, polyvinylidene chloride, polyvinyl acetate, ethyl cellulose, acetyl butyl cellulose or a polyurethane.

The photosensitive composites of the invention can be dissolved by a solvent capable of dissolving the aforesaid components and then coated on a support. The solvents which can be used include methyl cellosolve, ethyl cellosolve, methyl cellosolve acetate, ethyl cellosolve acetate, cyclohexane, methyl ethyl ketone, toluene, cyclohexanone, ethylene dichloride, ethyl acetate, dimethyl formamide and dimethyl sulfoxide; they can be used singly or in combination. A suitable concentration of the solid components in the coating solution is 2 to 50% by weight. The amount of the solid components in such a solution is suitably coated at the rate of 0.5—5 $g/m^2$, and preferably 1.5—3 $g/m^2$ in the case of a lithographic printing plate material. As for coating methods, any conventional one can be used, for example whirl coating, wire-bar coating, dipping coating, air-knife coating, roller coating, blade coating and curtain coating.

The supports onto which the photosensitive composites of the invention can be coated include metallic plates of, for example, aluminium, zinc or copper, a metal on which a metal such as zinc, copper or chromium has been vacuum evaporated, a paper sheet, a plastic film, a paper sheet or a plastic film on which a metal has been vacuum evaporated or a glass plate. The most preferred is an aluminium plate. In the case of an aluminium plate support in particular, it is preferable to carry out a surface treatment such as graining, desmut treatment, anodizing or sealing treatment if necessary. Any known treatment can be applied thereto. As for graining treatments, examples include a mechanical surface graining treatment

such as brush graining or ball graining, chemical graining, electrolytic etching or a combination of said mechanical graining and electrolytic graining.

As for desmut treatments, an alkaline etching treatment or an acid etching treatment are given as examples. Anodizing can be carried out by making an aluminium plate serve as an anode in an electric cell using either an aqueous solution or a non-aqueous solution in which an inorganic acid such as phosphoric acid, chromic acid, boric acid or sulfuric acid or an organic acid such as oxalic acid or sulfamic acid or a mixture thereof is dissolved. A sealing treatment can be carried out by dipping in an aqueous solution of sodium silicate, hot water and a hot aqueous solution of several inorganic or organic salts, or by immersion in a steam bath.

A lithographic printing plate material coated with a photosensitive composite of the invention is exposed to light such as a carbon-arc lamp, a mercury lamp, a metal halide lamp, a xenon lamp or a tungsten lamp through a transparent positive film and then developed with an alkaline solution; in this way only the unexposed area of the layer remains on the surface of the support to produce a positive-positive type relief image. Developing solution used for the development may be any kind of alkaline solution, specific examples being a solution of sodium hydroxide, potasium hydroxide, calcium hydroxide, sodium carbonate, potassium carbonate, sodium metaborate, sodium triphosphate, sodium diphosphate, sodium metasilicate or sodium formate. As occasion demands, it is possible to add to said developing solution an anionic or an amphoteric surface active agent, or an organic solvent such as an alcohol.

The lithographic printing plate materials and the photoresist materials each having a photosensitive composite of the invention within the photosensitive layer thereof possess good photosensitivity and excellent storage stability under high temperature and humidity conditions; the lithographic printing plate materials are scarcely affected by various processing chemicals such as dampening water containing alcohol. There is no lowering of the press life, so that a great number of excellent prints can be obtained.

The following Examples further illustrate the present invention.

Example 1

A sheet of aluminium plate was degreased by dipping in a 20% aqueous solution of sodium phosphate and was then subjected to electrolytic etching in 0.2N hydrochloric acid bath at an electric current density of 3A/dm$^2$, and thereafter anodized in a sulfuric acid bath. The amount anodized was 2 g/m$^2$. The anodized aluminium plate was further hot-water sealed; a sheet of aluminium plate-1, 0.24 mm thick was produced to serve as a support for a lithographic printing plate material. Onto said aluminium plate-1, the photosensitive solution having the following composition was coated by means of a whirl coating machine, and was dried for four minutes at 100°C; a lithographic printing plate material was thus obtained.

(Composition of the photosensitive solution)

| | |
|---|---|
| The condensation product of naphthoquinone-(1,2)-diazide-(2)-5-sulfonyl chloride and resorcinol-benzaldehyde resin (i.e. the synthetic product prepared in the process described in Example 1 in Japanese Patent Publication Open to Public Inspection No. 1044/1981) | 3.5 g |
| Copolymeric condensation resin of phenol.m-, p-mixed cresol.formaldehyde (in which the molar ratio of the phenol to the cresol is 3:7, and the average molecular weight thereof is 1500) | 8.0 g |
| Naphthoquinone-(1,2)-diazide-(2)-4-sulfonyl chloride | 0.15 g |
| Oil Blue No. 603 (mfd by Orient Chemical Ind. Co. Ltd.) | 0.2 g |
| Exemplified Compound (1) | 0.58 g |
| Methyl cellosolve | 100.0 g |

The amount coated by weight was approximately 2.7 g/m$^2$ after drying.

A step-tablet for measuring sensitivity (mfd by Eastman Kodak Co. — No. 2 — which is divided into 21 steps graded each by a density of 0.15) was brought into contact with the surface of the lithographic printing plate material thus prepared, and an exposure was made to the light source of a 2 KW metal halide lamp (mfd by Iwasaki Electric Co. Ltd. — Eyedolphin 2000) from a distance of 1 m, and development was made in a 4% aqueous solution of sodium metasilicate at 25°C for 45 seconds, and the sensitivity was measured.

A suitable exposure time was determined so that the area corresponding to the 4th step of the said grey-scale having 21 steps graded each by a density of 0.15 could be developed completely (i.e. said area

corresponding to the 4th step was clear upon development). Meanwhile, for the purpose of investigating the processing chemical resistance and the press life after storage, said lithographic printing plate material was preserved under torture testing conditions (i.e. a six-day preservation under the conditions of temperature at 55°C and humidity at 2%, and a six-day preservation under the conditions of temperature at 40°C and humidity at 80%) and exposed and developed and then the processing chemical resistance test was carried out to assess durability against the aqueous solution of isopropyl alcohol used in a Dahlgren damping system.

A printing plate having an image with the density gradation corresponding to the steps of the aforesaid grey-scale was dipped into a 35% aqueous solution of isopropyl alcohol for 24 hours at room temperature, and washed with water, and the image area rubbed with a piece of wet absorbent cotton; thus the degree of the erosion in the image area affected by processing chemicals was judged as compared with said image area before dipping in the aqueous solution of isopropyl alcohol.

The press life was evaluated in such a manner that the printing plate was used on an off-set printing machine (Komori Sprint L-25B) to carry out printing until the image area was too damaged for further printing and the numbers of the prints obtained by this time were evaluated.

### Control Example 1

A lithographic printing plate material was prepared using exactly the same process as that in Example 1, except that Exemplified Compound (1) was not added. With respect to the lithographic printing plate material thus prepared, the sensitivity measurements, the processing chemical resistance tests after storage, and the press life tests were carried out in a similar manner to Example 1.

### Control Example 2

a lithographic printing plate material was prepared in exactly the same way as that in Example 1, except that there was used 0.58 g of $\Delta^4$-tetrahydrophthalic anhydride described in Example 1 in Japanese Patent Publication Open to Public Inspection No. 80022/1977 in place of Exemplified compound (1) in Example 1. With respect to the lithographic printing plate material thus prepared, the sensitivity measurements, the processing chemical resistance tests after storage, and the press life tests were carried out in a similar manner to Example 1.

### Control Example 3

A lithographic printing plate material was prepared in exactly the same way as that in Example 1, except that there was used 0.58 g of maleic anhydride described in Example 2 in Japanese Patent Publication Open to Public Inspection No. 80022/1977 in place of Exemplified Compound (1) in Example 1. With respect to the lithographic printing plate material thus prepared, the sensitivity measurements, the processing chemical resistance tests after storage, and the press life tests were carried out, in a similar manner to Example 1.

The results of the above-mentioned tests for Example 1 and Control Examples 1 to 3 are shown in Table 1 and Table 2, respectively. As is obvious from Table 1 and Table 2, the six-membered cyclic acid-anhydride (i.e. Exemplified Compound (1)) provided greater sensitization effects than a five-membered cyclic acid-anhydride and its processing chemical resistance properties and press life were not inferior after storage. Further, in Table 1, it can be seen that the samples each containing a five-membered cyclic acid-anhydride possessed less development latitude, while the sensitivity thereof was increased after storage. On the other hand, the sample containing the six-membered cyclic acid-anhydride (i.e. Exemplified Compound (1)) of the invention gave less sensitivity fluctuations upon storage and also the development latitude thereof did not decrease.

TABLE 1

| | Suitable Exposure Time (Sensitivity) | | |
|---|---|---|---|
| | | The torture testing conditions | |
| | On the same day | 6-day preservation at a temperature of 55°C and a humidity of 2% | 6-day preservation at a temperature of 40°C and a humidity of 80% |
| Example–1 (The invention) | 45 sec. | 40 sec. | 45 sec. |
| Control Example–1 | 85 sec. | 88 sec. | 88 sec. |
| Control Example–2 | 70 sec. | 55 sec. | 48 sec. |
| Control Example–3 | 80 sec. | 65 sec. | 60 sec. |

In the above table, the contents of the cyclic acid-anhydride in the photosensitive composites are the same in Example 1, Control Examples 2 and 3.

TABLE 2

| | On the same day | | The torture testing conditions | | | |
|---|---|---|---|---|---|---|
| | | | 6-day preservation at the temperature of 55°C and the humidity of 2% | | 6-day preservation at the temperature of 40°C and the humidity of 80% | |
| | Chemical resistance | The number of prints | Chemical resistance | The number of prints | Chemical resistance | The number of prints |
| Example–1 (The invention) | O | $20 \times 10^4$ shts | O | $20 \times 10^4$ shts | O | $20 \times 10^4$ shts |
| Control Example–1 | O | $20 \times 10^4$ shts | O | $20 \times 10^4$ shts | O | $20 \times 10^4$ shts |
| Control Example–2 | O | $19 \times 10^4$ shts | X | $15 \times 10^4$ shts | Δ | $17 \times 10^4$ shts |
| Control Example–3 | O | $19 \times 10^4$ shts | X | $15 \times 10^4$ shts | Δ | $18 \times 10^4$ shts |

In the above table:

Mark O indicates no observation of any eroded image area.

Mark Δ indicates the observation of a little eroded image area, and

Mark X indicates the observation of a seriously eroded image area.

Example 2

A sheet of aluminium plate was grained by a brush graining treatment and then alkali-etching was applied thereto using sodium hydroxide solution, and subsequently an electrolytic graining surface treatment was applied using an aqueous solution of nitric acid and another alkali-etching was conducted with an aqueous solution of sodium hydroxide and then a desmut treatment was applied; an anodizing treatment was applied using an aqueous solution of sulfuric acid. The amount anodized was 2 $g/m^2$.

The aluminium plate-2 thus prepared to be used in a lithographic printing plate material was coated with the photosensitive solution having the following composition, by means of a whirl coating machine, and was then dried for four minutes at 100°C; a lithographic printing plate material was thus obtained.

(Composition of photosensitive solution)

| | |
|---|---|
| Esterified product of naphthoquinone-(1,2)-diazide-(2)-5-sulfonyl chloride and pyrogallol.acetone resin (which is described in Example 1 in US Patent No. 3 635 709) | 3.0 g |
| m-cresol.formaldehyde novolak resin | 7.0 g |
| Exemplified compound (1) | 0.5 g |
| p-t-butyl.formaldehyde novolak resin | 0.15 g |
| Oil-Blue No. 603 (mfd by Orient Chemical Co.) | 0.2 g |
| Methyl cellosolve acetate | 100 g |

The amount coated by weight after drying was approximately 2.7 $g/m^2$.

Another lithographic printing plate material, without addition of Exemplified compound (1), was prepared similarly.

With respect to the lithographic printing plate materials thus prepared, the sensitivity measurements and the tests for chemical resistance and the press life after storage were carried out in a similar manner to Example 1. The results thereof were that the proper exposure time (i.e. the sensitivity) were 50 seconds and 85 seconds respectively for that containing Exemplified compound (1) and that not containing it, while both plates possessed excellent chemical resistance and press life.

Example 3

The same aluminium plate as in Example 1 was coated with a photosensitive solution having the following composition, as in the case of Example 1, and was then dried; thus a lithographic printing plate material was prepared.

(Composition of photosensitive solution)

| | |
|---|---|
| Esterified products of naphthoquinone-(1,2)-diazide-(2)-5-sulfonyl chloride and m-cresol.formaldehyde novolak resin (Condensation ratio: 25 mol %) | 3.5 g |
| Copolymeric condensation resin of phenol.m-, p-mixed cresol.formaldehyde (Molar ratio of phenol to cresol was 2:8 and the average molecular weight was 1300) | 8.0 g |
| Exemplified Compound (6) | 0.58 g |
| Victoria Pure Blue BOH (mfd by Hodogaya Chemical Co.) | 0.2 g |
| Ethyl cellosolve | 100 g |

The amount coated by weight after drying was approximately 2.5 $g/m^2$.

Another lithographic printing plate material was prepared similarly but without Exemplified compound (6).

With respect to the lithographic printing plate materials thus prepared, sensitivity measurements and tests for chemical resistance and press life after storage were carried out similarly to the case of Example 1. The results thereof were that a suitable exposure time (i.e. the sensitivity) was 60 seconds and 90 seconds respectively for that containing Exemplified compound (6) and that not containing it, while both of the plates possessed excellent chemical resistance and printing durability.

Example 4

A lithographic printing plate material was obtained using exactly the same formula used in Example 3, except that Exemplified compound (4) was used in place of Exemplified compound (6).

With respect to the lithographic printing plate materials thus prepared, the sensitivity measurements and the tests for chemical resistance and the press life after storage were carried out in a similar manner to Example 1. The results thereof were that a suitable exposure time (i.e. the sensitivity) was 55 seconds, and the chemical resistance and the press life thereof were excellent even after storage.

Example 5

Acrylic anhydride (3.96 g) and 40 mg of benzoyl peroxide were dissolved in 4 ml of dry benzene and the solution thus obtained was gassed with nitrogen and then placed in a sealed tube. Heating was applied thereto for two hours at 65°C to solidify the contents. The contents thus solidified were dissolved in 100 ml of dry DMF and the thus obtained solution was poured into 500 ml of dry ether to precipitate the polymers. Thus, poly(acrylic anhydride) (i.e. exemplified compound(9)) (3 g) was obtained by filtration and drying under reduced pressure. The average molecular weight thereof was 25 000.

A lithographic printing plate material was prepared using exactly the same formula used in Example 3, except that the said poly(acrylic anhydride) (0.53 g) was used in place of Exemplified compound (6) used in Example 3.

The lithographic printing plate material thus obtained was tested for sensitivity, chemical resistance and the press life, similar to the case of Example 1; it was observed that the sensitivity thereof was as high as that in Examples 3 and 4 and that the chemical resistance and the press life thereof were not inferior even after storage.

**Claims**

1. A photosensitive composite comprising an o-quinone diazide compound, an alkali-soluble resin and a product comprising an acid-anhydride ring, characterised in that the acid-anhydride ring is six-membered.

2. A photosensitive composite according to claim 1, wherein said six-membered cyclic acid-anhydride product is a compound represented by the Formula:

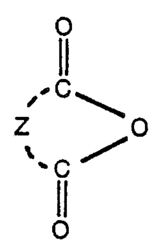

wherein Z represents a non-metallic group which forms a six-membered ring together with

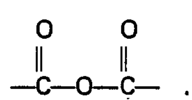 .

3. A photosensitive composite according to claim 1, wherein said six-membered cyclic acid-anhydride product is a compound represented by the Formulae:

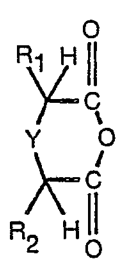

or

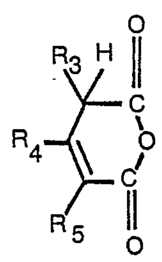

wherein Y represents an oxygen atom or a methylene group; $R_1$, $R_2$, $R_3$, $R_4$ and $R_5$ each independently represents a hydrogen or halogen atom or an alkyl, aralkyl or aryl group.

4. A photosensitive composite according to claim 3, wherein Y represents a methylene group.

5. A photosensitive composite according to claim 3, wherein said compound is glutaric anhydride.

6. A photosensitive composite according to claim 1, wherein said six-membered cyclic acid-anhydride product is a polymer comprising monomer units represented by the Formula:

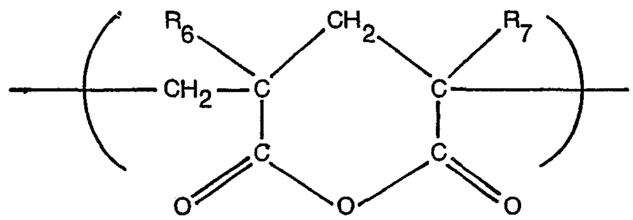

wherein $R_6$ and $R_7$ each independently represents a hydrogen atom, a halogen atom or an alkyl group.

7. A photosensitive composite according to any one of the preceding claims wherein the said six-membered cyclic acid-anhydride product is present in an amount of from 0.5—20% by weight based on the solids in the composite.

8. A lithographic printing plate material comprising on a support a photosensitive layer characterised in that the photosensitive layer comprises a composite as claimed in any one of the preceding claims.

9. A lithographic printing plate material according to claim 8, wherein said six-membered cyclic acid-anhydride product of the composite is present in the photosensitive layer in an amount from 0.5—20% by weight based on the solids in the composite.

**Patentansprüche**

1. Photoempfindliches Komposit, enthaltend eine O-Chinondiazid-Verbindung, ein alkalilösliches Harz und ein Produkt, welches einen Säureanhydridring enthält, dadurch gekennzeichnet, daß der Säureanhydridring sechs-gliedrig ist.

2. Photoempfindliches Komposit nach Anspruch 1, worin das sechs-gliedrige cyclische Säureanhydrid-Produkt eine Verbindung der Formel

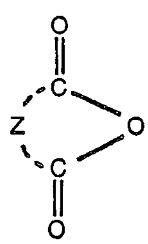 ist,

worin Z eine nicht-metallische Gruppe darstellt, die einen sechs-gliedrigen Ring zusammen mit

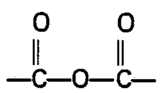

bildet.

3. Photoempfindliches Komposit nach Anspruch 1, worin das sechs-gliedrige cyclische Säureanhydrid-Produkt eine Verbindung der Formeln

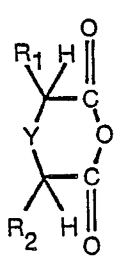

oder

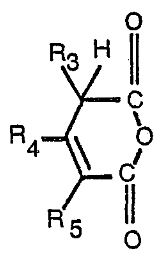

worin Y ein Sauerstoffatom oder eine Methylengruppe darstellt und $R_1$, $R_2$, $R_3$, $R_4$ und $R_5$ jeweils unabhängig voneinander ein Wasserstoffatom oder ein Halogenatom oder einen Alkyl-, Aralkyl- oder Arylrest bedeuten.

4. Photoempfindliches Komposit nach Anspruch 3, worin Y eine Methylengruppe darstellt.

5. Photoempfindliches Komposit nach Anspruch 3, worin die Verbindung Glutarsäureanhydrid ist.

6. Photoempfindliches Komposit nach Anspruch 1, worin das sechs-gliedrige cyclische Säureanhydrid-Produkt ein Polymer ist, welches Monomereinheiten enthält, die durch die Formel

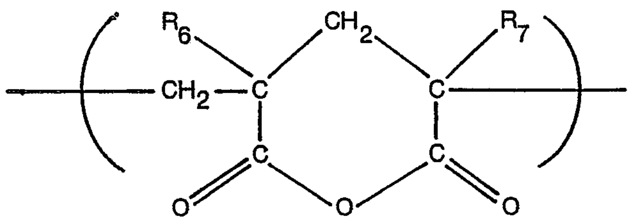

angegeben sind, worin $R_6$ und $R_7$ jeweils unabhängig voneinander ein Wasserstoffatom, ein Halogenatom oder einen Alkylrest bedeuten.

7. Photoempfindliches Komposit nach einem der voranstehenden Ansprüche, worin das sechs-gliedrige cyclische Säureanhydrid-Produkt in einer Menge von 0,5 bis 20 Gew.-% bezogen auf die Feststoffe in dem Komposit vorhanden ist.

8. Lithographisches Druckplattenmaterial, welches auf einem Träger eine photoempfindliche Schicht enthält, dadurch gekennzeichnet, daß die photoempfindliche Schicht ein Komposit nach einem der voranstehenden Ansprüche umfaßt.

9. Lithographisches Druckplattenmaterial nach Anspruch 8, worin das sechs-gliedrige cyclische Säureanhydrid-Produkt des Komposits in der photoempfindlichen Schicht in einer Menge von 0,5 bis 20 Gew.-% bezogen auf die Feststoffe in dem Komposit vorhanden ist.

**Revendications**

1. Un produit composite photosensible comprenanat un composé de o-quinone diazide, une résine soluble dans les alkalis et un produit comprenant un cycle anhydride d'acide, caractérisé par le fait que le cycle anhydride d'acide a six chaînons.

2. Un produit composite photosensible selon la revendication 1, dans lequel ledit anhydride d'acide cyclique à six chaînons est un composé représenté par la formule:

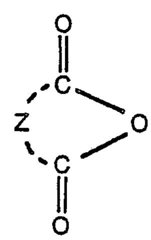

dans laquelle Z représente un groupement non métallique qui forme un cycle à six chaînons avec le groupement —CO—O—CO—.

3. Un produit composite photosensible selon la revendication 1, dans lequel ledit anhydride d'acide cyclique à six chaînons est un composé représenté par les formules:

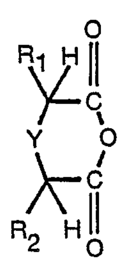

ou

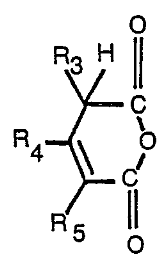

dans lesquelles Y représente un atome d'oxygène ou un groupement méthylène, $R_1$, $R_2$, $R_3$, $R_4$ et $R_5$ représentent chacun indépendamment un atome d'hydrogène ou d'halogène ou un groupement alkyle, aralkyle ou aryle.

4. Un produit composite photosensible selon la revendication 3, dans lequel Y représente un groupement méthylène.

5. Un produit composite selon la revendication 3, dans lequel ledit produit est l'anhydride glutarique.

6. Un produit composite photosensible selon la revendication 1, dans lequel ledit anhydride d'acide cyclique à six chaînons est un polymère comprenant des motifs monomères représentés par la formule:

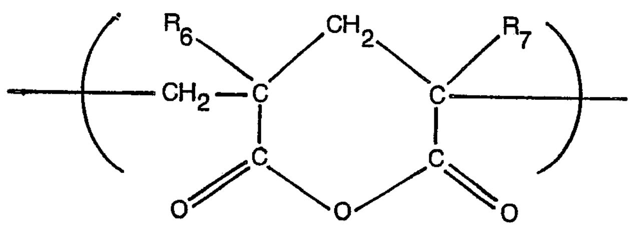

dans laquelle $R_6$ et $R_7$ représentent chacun indépendamment un atome d'hydrogène, un atome d'halogène ou un groupement alkyle.

7. Un produit composite photosensible selon l'une quelconque des revendications précédentes, dans lequel ledit anhydride d'acide cyclique à six chaînons est présent dans une proportion de 0,5—20% en poids par rapport aux solides dans le composite.

8. Un matériau de plaque d'impression lithographique comprenant sur un support une couche photosensible, caractérisé par le fait que la couche photosensible comprend un produit composite tel que revendiqué dans l'une quelconque des revendications précédentes.

9. Un matériau de plaque d'impression lithographique selon la revendication 8, dans lequel ledit anhydride d'acide cyclique à six chaînons du composite est présent dans la couche photosensible dans une proportion de 0,5—20% en poids par rapport aux solides dans le composite.